# EUROPÄISCHE PATENTSCHRIFT

(11) **EP 3 937 219 B1**
(45) Veröffentlichungstag und Bekanntmachung des Hinweises auf die Patenterteilung: **30.08.2023**
(21) Anmeldenummer: 20184139.2
(22) Anmeldetag: 06.07.2020
(51) Int. Cl.: F16K 51/02, H01L 21/677, H01J 37/32, F16K 3/02, H01L 21/67, C23C 16/455, C23C 16/44

(54) **VERFAHREN ZUM ERZEUGEN EINES GASVORHANGS AUS SPÜLGAS IN EINEM SCHLITZVENTILTUNNEL UND SCHLITZVENTILTUNNEL**
METHOD FOR GENERATING A GAS CURTAIN FROM PURGE GAS IN A SLIT VALVE TUNNEL AND SLIT VALVE TUNNEL
PROCÉDÉ DE FABRICATION D'UN RIDEAU DE GAZ À PARTIR DE GAZ DE PURGE DANS UN TUNNEL DE SOUPAPE À FENTE ET TUNNEL DE SOUPAPE À FENTE

(43) Veröffentlichungstag der Anmeldung: 12.01.2022
(73) Patentinhaber: Siltronic AG, 81677 München (DE)
(72) Erfinder: Moos, Patrick, 84568 Pleiskirchen (DE); Feldmann, Marco, 09600 Oberschöna (DE)
(74) Vertreter: Staudacher, Wolfgang

(56) Entgegenhaltungen:
- DE-A1-102016 110 788
- US-A- 5 997 588
- US-A1- 2006 240 680
- US-A1- 2009 272 324
- US-A1- 2010 229 793
- US-A1- 2014 060 433
- US-A1- 2015 083 330

## Beschreibung

Gegenstand der Erfindung ist ein Verfahren zum Erzeugen eines Gasvorhangs aus Spülgas in einem Schlitzventil-Tunnel einer Vorrichtung zum Behandeln einer Halbleiterscheibe, beispielsweise einer Vorrichtung zum thermischen Behandeln der Halbleiterscheibe oder zum Abscheiden einer Schicht auf einer oberen Seite der Halbeiterscheibe. Gegenstand der Erfindung ist auch ein Schlitzventil-Tunnel für eine solche Vorrichtung.

### Stand der Technik / Probleme

In US 2010 0 190 343 A1 ist eine Vorrichtung zum Behandeln einer Halbleiterscheibe dargestellt, die typische Module umfasst, insbesondere eine Prozesskammer, eine Transferkammer und eine Ladeschleuse (load lock). Eine zu behandelnde Halbleiterscheibe wird in einer vorgegebenen Reihenfolge in die Module transportiert. Die Module sind durch Schnittstellen (ports) getrennt.

In KR 10 1 875 305 B1 wird vorgeschlagen, als Schnittstelle ein Schlitzventil-Tunnel zu verwenden und ein Spülgas über die Halbleiterscheibe während des Transports der Halbleiterscheibe durch den Schlitzventil-Tunnel zu leiten, um die Halbleiterscheibe vor Verunreinigung durch Partikel zu schützen.

In US 2015 0 083 330 A1 ist ein Schlitzventil-Tunnel beschrieben, bei dem das Spülgas durch Löcher von oben nach unten zur durchtransportierten Halbleiterscheibe geleitet wird.

Die Dokumente US2006/0240680-A1 und US2009/0272324-A1 zeigen weitere Beispiele aus dem Stand der Technik.

Es besteht darüber hinaus Verbesserungsbedarf, weil Partikel sich im Schlitzventil-Tunnel ansammeln können und der Schlitzventil-Tunnel selbst mit der Zeit zu einer Partikelquelle werden kann.

Aufgabe der vorliegenden Erfindung ist es, die Gefahr der Verunreinigung von Halbleiterscheiben durch Partikel beim Transport durch einen Schlitzventil-Tunnel weitgehend zu beseitigen.

Die Aufgabe der Erfindung wird gelöst durch ein Verfahren zum Erzeugen eines Gasvorhangs aus Spülgas in einem Schlitzventil-Tunnel einer Vorrichtung zum Behandeln einer Halbleiterscheibe, dadurch gekennzeichnet, dass das Spülgas zu zwei Enden eines Kanals geleitet wird, der in einem Kopfabschnitt des Schlitzventil-Tunnels angeordnet und mit einem abnehmbaren Deckel abgedeckt ist, und das Spülgas durch einen Schlitz im Boden des Kanals als Gasvorhang zu einem Fußabschnitt des Schlitzventil-Tunnels geleitet wird, während eine Hableiterscheibe durch eine Durchgangsöffnung zwischen dem Kopfabschnitt und dem Fußabschnitt des Schlitzventil-Tunnels transportiert wird.

Gegenstand der Erfindung ist darüber hinaus ein Schlitzventil-Tunnel einer Vorrichtung zum Behandeln einer Halbleiterscheibe, umfassend einen Kopfabschnitt, einen Fußabschnitt und eine Durchgangsöffnung zwischen dem Kopfabschnitt und dem Fußabschnitt zum Transportieren der Halbleiterscheibe durch den Schlitzventil-Tunnel entlang eines Transportwegs, gekennzeichnet durch
eine Vertiefung auf einer oberen Seite des Kopfabschnitts;
einen abnehmbaren Deckel zum Abdecken der Vertiefung;
einen Kanal in der Vertiefung, der sich quer zum Transportweg erstreckt;
einen Schlitz am Boden des Kanals für den Durchtritt von Spülgas;
Bohrungen im Kopfabschnitt zum Zuführen des Spülgases zu zwei Enden des Kanals, wodurch beim Zuführen des Spülgases ein Gasvorhang entsteht, der vom Kopfabschnitt zum Fußabschnitt des Schlitzventil-Tunnels gerichtet ist.

Indem das Spülgas zu beiden Enden des Kanals hin und durch den Schlitz des Kanals zur Halbleiterscheibe weitergeleitet wird, entsteht ein homogener Gasvorhang, so dass Partikel unabhängig von ihrer Position auf der Halbleiterscheibe mit der gleichen Wirkkraft entfernt werden können. Indem der Kanal durch einen abnehmbaren Deckel zugänglich ist, ist der maßgebliche Bereich, in dem sich Partikel ansammeln können und der zu einer Quelle für die Verunreinigung von Halbleiterscheiben durch Partikel werden kann, für Reinigungsmaßnahmen ohne Weiteres zugänglich.

Der Gasvorhang erstreckt sich über eine Strecke, die größer als der Durchmesser einer durch die Durchgangsöffnung des Schlitzventil-Tunnels transportierten Halbleiterscheibe ist. Entsprechend einer Ausführungsform beträgt die Länge der Strecke und damit die Länge des Kanals mehr als 300 mm, besonders bevorzugt 320 mm. Entsprechend einer Ausführungsform wird die Breite des Schlitzes im Boden des Kanals eingestellt, um eine gewünschte Strömungsgeschwindigkeit des Gasvorhangs zu erreichen.

Vorzugsweise wird der Deckel in vorbestimmten Abständen abgenommen, beispielsweise im Zuge einer Wartung der Vorrichtung zur Behandlung der Halbleiterscheibe, und anschließend werden der Deckel, die ihn aufnehmende Vertiefung und der Kanal gereinigt und getrocknet. Reinigung und Trocknung lassen sich vergleichsweise schnell und ohne besonderen Aufwand durchzuführen.

Der Deckel füllt die Vertiefung aus und ist auf der oberen Seite des Kopfabschnitts des Schlitzventil-Tunnels abnehmbar befestigt. Entsprechend einer Ausführungsform sind Schrauben das Befestigungsmittel, vorzugsweise Schrauben aus Kunststoff oder Keramik. Entsprechend einer Ausführungsform ist eine Dichtung vorhanden, die den Durchtritt von Spülgas zwischen Deckel und Vertiefung verhindert.

Der Schlitzventil-Tunnel hat eine Vorderseite und eine Rückseite. Entsprechend einer Ausführungsform ist die Vorderseite diejenige Seite, die an eine Transferkammer angrenzt, und die Rückseite diejenige Seite, die an eine Prozesskammer oder an eine Schleusenkammer angrenzt.

Im Kopfabschnitt des Schlitzventil-Tunnels sind zwei Bohrungen zum Zuführen von Spülgas zu den zwei Enden des Kanals angeordnet. Entsprechend einer Ausführungsform befinden sich die Bohrungen auf der Rückseite des Schlitzventil-Tunnels im Bereich zweier abgerundeter oberer Ecken der Rückseite.

Der Schlitzventil-Tunnel ist durch eine Tür abschließbar. Entsprechend einer Ausführungsform verschließt die Tür die Durchgangsöffnung auf der Vorderseite des Schlitzventil-Tunnels.

Der Schlitzventil-Tunnel ist Bestandteil einer Vorrichtung zum Behandeln einer Halbleiterscheibe. Entsprechend einer Ausführungsform handelt es sich um eine Vorrichtung zum Abscheiden einer epitaktischen Schicht auf einer Substratscheibe, vorzugsweise um eine Vorrichtung zum Abscheiden einer epitaktischen Schicht aus Silizium auf einer Substratscheibe aus einkristallinem Silizium. Entsprechend einer anderen Ausführungsform handelt es sich um eine Vorrichtung zur Wärmebehandlung einer Halbleiterscheibe, vorzugsweise einer Halbleiterscheibe aus einkristallinem Silizium.

Die Erfindung wird nachfolgend unter Bezugnahme auf Zeichnungen weiter vorgestellt.

### Kurzbeschreibung der Figuren

**Fig. 1** zeigt eine bevorzugte Ausführungsform des Schlitzventil-Tunnels in perspektivischer Darstellung.
**Fig. 2** zeigt den Schlitzventil-Tunnel gemäß Fig. 1 mit angehobenem Deckel.
**Fig. 3** zeigt eine Sicht auf die Rückseite des Schlitzventil-Tunnels gemäß Fig. 1 bei aktivem Gasvorhang.
**Fig. 4** zeigt eine schematische Darstellung des Schlitzventil-Tunnels gemäß Fig. 1 von der Seite.

### Liste der verwendeten Bezugszeichen

- **1**: Schlitzventil-Tunnel
- **2**: Kopfabschnitt
- **3**: Fußabschnitt
- **4**: Durchgangsöffnung
- **5**: Rückseite
- **6**: Deckel
- **7**: Bohrungen
- **8**: Vertiefung
- **9**: Kanal
- **10**: Enden
- **11**: Gasvorhang
- **12**: Transportweg
- **A**: Modul
- **B**: Modul

### Detaillierte Beschreibung erfindungsgemäßer Ausführunqsbeispiele

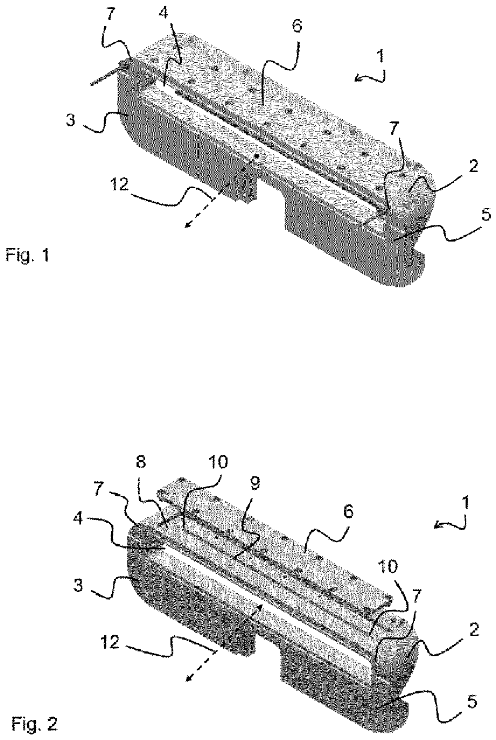

Fig. 1 zeigt eine bevorzugte Ausführungsform des Schlitzventil-Tunnels 1 in perspektivischer Darstellung. Der Schlitzventil-Tunnel 1 umfasst einen Kopfabschnitt 2, einen Fußabschnitt 3 und eine Durchgangsöffnung 4 zwischen dem Kopfabschnitt und dem Fußabschnitt. In dieser Darstellung ist die Rückseite 5 des Schlitzventil-Tunnels 1 zu sehen. Ein abnehmbarer Deckel 6 ist mittels Schrauben auf der oberen Seite des Kopfabschnitts befestigt. Im Bereich zweier abgerundeter oberer Ecken der Rückseite 5 des Schlitzventil-Tunnels 1 sind zwei Bohrungen 7 vorgesehen, durch die Spülgas zu den beiden Enden eines Kanals geleitet wird, den der Deckel 6 abdeckt. Pfeile symbolisieren die Strömungsrichtung des Spülgases.

Fig. 2 zeigt den Schlitzventil-Tunnel 1 gemäß Fig. 1 mit angehobenem Deckel 6. Auf der oberen Seite des Kopfabschnitts 2 ist eine Vertiefung 8 vorgesehen, in die der Deckel 6 formschlüssig passt. In der Vertiefung ist ein Kanal 9 mit zwei Enden 10 eingearbeitet, der sich nahezu über die Breite der Durchgangsöffnung 4 erstreckt und nach unten zu einem Schlitz (nicht dargestellt) geöffnet ist.

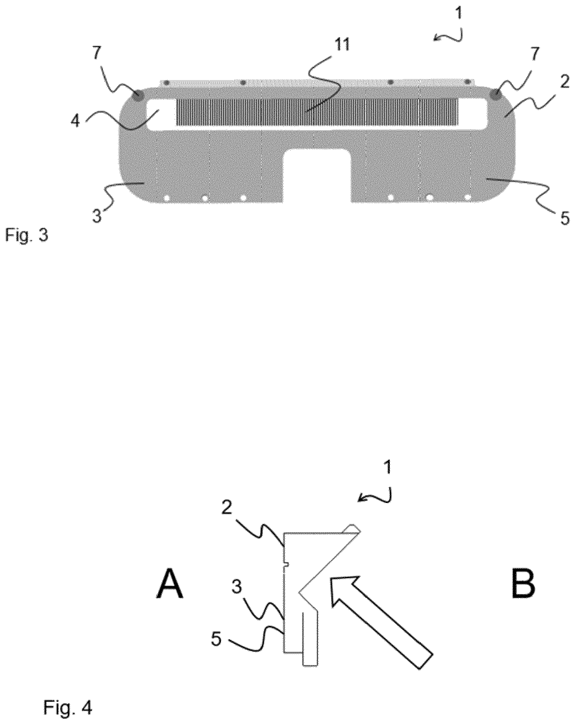

Fig. 3 zeigt eine Sicht auf die Rückseite 3 des Schlitzventil-Tunnels gemäß Fig. 1 bei aktivem Gasvorhang 11 aus Spülgas.

Fig. 4 zeigt eine schematische Darstellung des Schlitzventil-Tunnels gemäß Fig. 1 von der Seite, wobei die Rückseite 5 des Schlitzventil-Tunnels 1 an ein Modul Ader Vorrichtung zum Behandeln einer Halbleiterscheibe und die Vorderseite des Schlitzventil-Tunnels 1 an ein Modul B der Vorrichtung angrenzt. Der Pfeil symbolisiert die Bewegungsrichtung einer Tür (nicht dargestellt) zum Verschließen der Durchgangsöffnung 4. Bei dem Modul A handelt es sich beispielsweise um eine Prozesskammer oder eine Schleusenkammer und bei Modul B um eine Transferkammer.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen durch den Schutzbereich der Ansprüche abgedeckt sein.

## Patentansprüche

1. Verfahren zum Erzeugen eines Gasvorhangs aus Spülgas in einem Schlitzventil-Tunnel (1) einer Vorrichtung zum Behandeln einer Halbleiterscheibe, wobei
das Spülgas zu zwei Enden eines Kanals (9) geleitet wird, der in einem Kopfabschnitt (2) des Schlitzventil-Tunnels (1) angeordnet und mit einem abnehmbar befestigten Deckel (6) abgedeckt ist, wobei eine obere Seite
des Kopfabschnitts (2) eine Vertiefung (8) aufweist,
und das Spülgas durch einen Schlitz im Boden des Kanals (9) als Gasvorhang (11) zu einem Fußabschnitt des Schlitzventil-Tunnels (1) geleitet wird, während eine Halbleiterscheibe durch eine Durchgangsöffnung (4) zwischen dem Kopfabschnitt (2) und dem Fußabschnitt (3) des Schlitzventil-Tunnels (1) transportiert wird.

2. Verfahren nach Anspruch 1, **dadurch gekennzeichnet, dass** der Deckel (6) vor oder nach dem Erzeugen des Gasvorhangs (11) abgenommen wird, und der Deckel (6),
die ihn aufnehmende Vertiefung (8) und der Kanal (9) gereinigt werden.

3. Schlitzventil-Tunnel (1) einer Vorrichtung zum Behandeln einer Halbleiterscheibe, umfassend einen Kopfabschnitt (2), einen Fußabschnitt (3) und eine Durchgangsöffnung (4) zwischen dem Kopfabschnitt (2) und dem Fußabschnitt (3) zum Transportieren der Halbleiterscheibe durch den Schlitzventil-Tunnel (1) entlang eines Transportwegs (12),
eine Vertiefung (8) auf einer oberen Seite des Kopfabschnitts (2);
einen abnehmbar befestigten Deckel (6) zum Abdecken der Vertiefung (8);
einen Kanal (9) in der Vertiefung (8), der sich quer zum Transportweg (12) erstreckt;
einen Schlitz am Boden des Kanals (9) für den Durchtritt von Spülgas;
Bohrungen (7) im Kopfabschnitt (2) zum Zuführen des Spülgases zu zwei Enden (10) des Kanals (9), wodurch beim Zuführen des Spülgases ein Gasvorhang (11) entsteht, der vom Kopfabschnitt (2) zum Fußabschnitt (3) des Schlitzventil-Tunnels (1) gerichtet ist.

## Claims

1. Method for generating a gas curtain from purge gas in a slot valve tunnel (1) of an apparatus for treating a semiconductor wafer, **characterized in that**
the purge gas is led to two ends of a channel (9) arranged in a head portion (2) of the slit valve tunnel (1) and covered with a removably fixed lid (6), and the purge gas is led through a slit in the bottom of the channel (9) as a gas curtain (11) to a foot portion of the slit valve tunnel (1), while a semiconductor wafer is transported through a through hole (4) between the head portion (2) and the foot portion (3) of the slit valve tunnel (1).

2. Method according to claim 1, **characterized in that** the cover (6) is removed before or after the gas curtain (11) is produced, and the cover (6), a recess (8) receiving it and the channel (9) are cleaned.

3. A slit valve tunnel (1) of an apparatus for treating a semiconductor wafer, comprising a head portion (2), a foot portion (3), and a through hole (4) between the head portion (2) and the foot portion (3) for transporting the semiconductor wafer through the slit valve tunnel (1) along a transport path (12), **characterized by**
a recess (8) on an upper side of the head portion (2);
a removably attached lid (6) for covering the recess (8);
a channel (9) in the recess (8) extending transversely to the transport path (12);
a slot at the bottom of the channel (9) for the passage of purge gas;
Holes (7) in the head portion (2) for supplying the purge gas to two ends (10) of the duct (9), thereby creating a gas curtain (11) directed from the head portion (2) to the foot portion (3) of the slot valve tunnel (1) when the purge gas is supplied.

## Revendications

1. Procédé de production d'un rideau de gaz à partir d'un gaz de balayage dans un tunnel de soupape à fente (1) d'un dispositif de traitement d'une plaquette semi-conductrice, **caractérisé en ce que**
le gaz de purge est dirigé vers deux extrémités d'un canal (9) disposé dans une partie de tête (2) du tunnel de vanne à fente (1) et recouvert d'un couvercle (6) fixé de manière amovible, et le gaz de purge est conduit à travers une fente dans le fond du canal (9) en tant que rideau de gaz (11) vers une section de pied du tunnel de vanne à fente (1), tandis qu'une plaquette semi-conductrice est transportée à travers une ouverture de passage (4) entre la section de tête (2) et la section de pied (3) du tunnel de vanne à fente (1).

2. Procédé selon la revendication 1, **caractérisé en ce que** le couvercle (6) est retiré avant ou après la génération du rideau de gaz (11), et le couvercle (6), une cavité (8) qui le reçoit et le canal (9) sont nettoyés.

3. Tunnel (1) à vanne à fente d'un dispositif de traitement d'une plaquette semi-conductrice, comprenant une partie de tête (2), une partie de pied (3) et une ouverture de passage (4) entre la partie de tête (2) et la partie de pied (3) pour transporter la plaquette semi-conductrice à travers le tunnel (1) à vanne à fente le long d'un trajet de transport (12), **caractérisé par**
un renfoncement (8) sur un côté supérieur de la partie de tête (2);
un couvercle (6) fixé de manière amovible pour recouvrir la cavité (8);
un canal (9) dans la cavité (8), qui s'étend transversalement au trajet de transport (12); une fente au fond du canal (9) pour le passage du gaz de rinçage;
des alésages (7) dans la section de tête (2) pour amener le gaz de purge aux deux extrémités (10) du canal (9), créant ainsi, lors de l'amenée du gaz de purge, un rideau de gaz (11) qui est dirigé de la section de tête (2) vers la section de pied (3) du tunnel de vanne à fente (1).
